(19) Europäisches Patentamt
European Patent Office
Office européen des brevets

(11) **EP 2 516 690 B1**

(12) **FASCICULE DE BREVET EUROPEEN**

(45) Date de publication et mention de la délivrance du brevet:
**27.11.2013 Bulletin 2013/48**

(51) Int Cl.:
***C23C 14/00*** (2006.01)   ***C23C 14/06*** (2006.01)
***C23C 14/56*** (2006.01)

(21) Numéro de dépôt: **10805247.3**

(86) Numéro de dépôt international:
**PCT/FR2010/000792**

(22) Date de dépôt: **29.11.2010**

(87) Numéro de publication internationale:
**WO 2011/067480 (09.06.2011 Gazette 2011/23)**

(54) **DEPOT D'UNE COUCHE MINCE DE Cu(In,Ga)X2 PAR PULVERISATION CATHODIQUE**

KATHODENSPUTTERABSCHEIDUNG EINER CU(IN, GA)X2-DÜNNSCHICHT

CATHODE SPUTTER DEPOSITION OF A CU(IN, GA)X2 THIN FILM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2009 FR 0905811**

(43) Date de publication de la demande:
**31.10.2012 Bulletin 2012/44**

(73) Titulaire: **Commissariat à l'Énergie Atomique et aux Énergies Alternatives 75015 Paris (FR)**

(72) Inventeurs:
• **PERRAUD, Simon**
  **F-83150 Bandol (FR)**
• **DUFOURCQ, Joël**
  **F-64270 Puyoo (FR)**
• **GAILLARD, Frédéric**
  **F-38500 Voiron (FR)**
• **NOEL, Sébastien**
  **F-38140 Rives (FR)**
• **ROUVIERE, Emmanuelle**
  **F-38120 Saint-egreve (FR)**

(74) Mandataire: **Noel, Chantal Odile et al Cabinet Orès 36, rue de St Pétersbourg 75008 Paris (FR)**

(56) Documents cités:
**US-A- 4 976 996        US-A- 5 439 575
US-A1- 2004 063 320**

• **SEEGER S ET AL: "Reactive magnetron sputtering of CuInS2 absorbers for thin film solar cells: Problems and prospects", THIN SOLID FILMS ELSEVIER SEQUOIA S.A. SWITZERLAND, vol. 517, no. 10, 31 mars 2009 (2009-03-31), pages 3143-3147, XP002574951, ISSN: 0040-6090**

EP 2 516 690 B1

**Description**

L'invention concerne un procédé et un dispositif de dépôt d'un film en un matériau semi-conducteur de formule $Cu(In,Ga)X_2$ où X est S ou Se.

Les couches, en particulier minces, du matériau semi-conducteur $Cu(In,Ga)Se_2$ ou $Cu(In,Ga)S_2$, appelé ci-après (CIGX), sont utilisées pour la réalisation de cellules photovoltaïques performantes à bas coût, car il s'agit d'un procédé facilement applicable au cas des dépôts sur des substrats de grandes surfaces, de l'ordre de 1 m$^2$ ou plus.

On connaît différents procédés pour former une couche mince de CIGX, en particulier de CIGSe.

Un de ces procédés est un procédé de pulvérisation cathodique qui comporte deux étapes réalisées dans deux équipements distincts : la première étape consiste à déposer par pulvérisation cathodique une couche mince contenant les précurseurs métalliques (Cu, In et Ga), et la deuxième étape consiste en une sélénisation ou sulfurisation de cette couche métallique par recuit dans une atmosphère contenant du Se ou du S (sous forme de vapeur de Se ou S, de gaz $H_2Se$ ou $H_2S$, etc...), afin de former le composé voulu.

Un tel procédé est décrit par Ermer et al. dans le brevet US n°4,798,660 (1989**).**

Afin de réduire la durée du procédé et le coût d'investissement, Thornton et al. dans le brevet US n°5,439,575 (1995), ont proposé de former la couche mince de CIGSe, par une technique de pulvérisation cathodique en une seule étape.

Dans ce procédé, les éléments métalliques (Cu, In et Ga) sont apportés sur le substrat par pulvérisation cathodique, alors que le Se arrive sur le substrat, sous forme de vapeur de Se évaporée à partir d'un creuset situé lui-même dans la même enceinte de pulvérisation cathodique.

Le substrat doit être chauffé pendant le dépôt.

Les couches minces de CIGSe élaborées par ce procédé permettent de réaliser des cellules photovoltaïques avec un rendement énergétique supérieur à 10% (Nakada et al., Jpn.J.Appl.Phys.34, 4715 (1995**)).**

Dans le procédé hybride combinant la pulvérisation cathodique et l'évaporation, le sélénium est apporté sous forme de vapeur de sélénium évaporée à partir d'un creuset.

Mais l'évaporation à partir d'un creuset donne lieu à un flux de vapeur dirigé selon une distribution angulaire relativement large et il est de plus connu que le sélénium arrivant en excès sur le substrat chauffé est réévaporé.

Par conséquent, l'enceinte se retrouve entièrement saturée en vapeur de sélénium, qui se condense très facilement sur toute surface non chauffée. Le même problème se pose avec le soufre.

Autrement dit, des dépôts parasites de sélénium ou de soufre apparaissent à la fois sur les cibles de pulvérisation, ce qui rend difficile le contrôle des taux de pulvérisation et donc des vitesses de dépôt, mais aussi sur toutes les parois froides de l'enceinte, ce qui oblige à assurer une maintenance fréquente de l'équipement.

L'invention vise à pallier les inconvénients des procédés de l'art antérieur en proposant un procédé et un dispositif pour former une couche, en particulier mince, de CIGX, où X est Se ou S, par une technique de pulvérisation cathodique en une seule étape mais dans lequel le sélénium ou le soufre ne se dépose pas, ou moins, sur les parois froides de la chambre de pulvérisation cathodique.

A cet effet, l'invention propose un dispositif pour le dépôt d'un film de $Cu(In,Ga)X_2$, où X est Se ou S ou un mélange des deux, sur au moins une surface d'un substrat, comprenant une chambre de pulvérisation cathodique, comprenant :

- un porte-substrat ,
- un moyen de chauffage du porte-substrat,
- au moins un porte cible de pulvérisation,
  le porte substrat étant situé en regard du au moins un porte cible de pulvérisation, et écarté de celui-ci,
- un premier tube d'injection 3 d'un premier flux laminaire de gaz inerte contenant X ou un précurseur de X, sous forme vapeur,

caractérisé en ce qu'il comprend, de plus un second tube d'injection d'un second flux laminaire de gaz inerte, dont l'orifice d'entrée dans la chambre de pulvérisation cathodique est situé entre l'orifice d'entrée dans la chambre de pulvérisation cathodique du premier tube d'injection et le au moins porte cible, de sorte que le second flux laminaire de gaz inerte entrant par l'orifice d'entrée du second tube d'injection est parallèle au premier flux laminaire de gaz inerte contenant X ou un précurseur de celui-ci, sous forme vapeur, et confine le premier flux laminaire de gaz inerte contenant X ou un précurseur de X sous forme vapeur au voisinage du porte substrat.

Dans un premier mode de réalisation préféré, le dispositif de l'invention comprend de plus une enceinte comprenant des moyens de vaporisation de X, cette enceinte étant en relation de fluide avec le premier tube d'injection et la chambre de pulvérisation cathodique.

Dans un second mode de réalisation préféré, le dispositif de l'invention comprend une enceinte comprenant des moyens pour créer un plasma pour décomposer et vaporiser un précurseur de X, cette enceinte étant relation de fluide avec le premier tube d'injection et la chambre de pulvérisation cathodique.

Dans tous les modes de réalisation, la chambre de pulvérisation cathodique comprend, de plus, et de préférence, une grille éventuellement munie des moyens de refroidissement, la grille s'étendant sur toute la longueur de la chambre de pulvérisation cathodique parallèlement au porte-substrat et entre l'orifice d'entrée du premier tube d'injection et l'orifice du second tube d'injection.

Dans un mode de réalisation particulier, le dispositif de l'invention comprend deux cibles de pulvérisation situées l'une à côté de l'autre.

Mais le dispositif de l'invention peut également comprendre trois cibles de pulvérisation situées les unes à côtés des autres.

L'invention propose également un procédé de dépôt d'un film en $Cu(In,Ga)X_2$ où X est Se ou S ou un mélange des deux, qui comprend une étape de dépôt, par pulvérisation cathodique, de Cu, In et Ga à partir d'au moins une cible de pulvérisation sur au moins une surface d'un substrat, simultanément à une étape de dépôt en phase vapeur de X sur ladite au moins une surface, dans une chambre de pulvérisation cathodique, caractérisé en ce que X, ou un précurseur de celui-ci, sous forme vapeur, est amené sous forme d'une premier flux gazeux laminaire dont le chemin de parcours est parallèle à la au moins une surface du substrat et en contact avec celle-ci, simultanément avec un second flux gazeux laminaire de gaz inerte dont le chemin de parcours est :

- parallèle au chemin de parcours du premier flux gazeux laminaire, et
- entre le chemin de parcours du premier flux gazeux laminaire et la surface de la (des) cible(s) de pulvérisation, confinant ainsi le premier flux gazeux laminaire au voisinage du substrat.

Selon une caractéristique avantageuse, la vitesse du second flux laminaire gazeux est supérieure à la vitesse du premier flux laminaire gazeux.

Avantageusement, les premier et second flux laminaires gazeux ont chacun indépendamment l'un de l'autre, un nombre de Knudsen $K = L/a$ où $L$ est la distance moyenne parcourue par un atome ou une molécule entre deux collisions et $a$ est une longueur caractéristique, du même ordre de grandeur que, ou égale à, la distance entre la (les) cible(s) de pulvérisation et le substrat, tel que $\leq 10^{-2}$ et/ou un nombre de Reynolds $R \leq 1000$.

Dans un premier mode de mise en oeuvre préféré, X est déposé à partir d'un précurseur de X de formule $R_2X$ où R est H, Me, Et, iPr ou tBu.

Mais X en tant que tel peut également être vaporisé et entraîné dans ledit premier flux laminaire gazeux contenant un gaz inerte tel que d'argon dans la chambre de pulvérisation cathodique.

De préférence, ledit second flux laminaire est un flux laminaire d'argon.

Dans un mode de mise en oeuvre particulier, le précurseur de X est décomposé par plasma avant injection dans la chambre de pulvérisation cathodique.

De préférence, ledit premier flux laminaire et ledit second flux laminaire sont séparés l'un de l'autre par une grille, de préférence, refroidie.

L'invention sera mieux comprise et d'autres caractéristiques et avantages de celle-ci apparaîtront plus clairement à la lecture de la description explicative qui suit et qui est faite en référence à la figure unique annexée qui représente schématiquement un dispositif selon l'invention pour la mise en oeuvre du procédé selon l'invention.

Le dispositif de l'invention sera décrit en se référant à la figure unique annexée qui représente schématiquement un tel dispositif.

Comme on le voit sur la figure, le dispositif selon l'invention, pour le dépôt d'un film, en particulier mince, en général d'une épaisseur comprise entre 100nm et 5μm inclus, de préférence comprise entre 1 et 2 μm inclus, d'un composé de Cu(In, Ga)X où X est soit du sélénium (Se), soit du soufre (S), comprend une chambre, notée 1 dans la figure, de pulvérisation cathodique classique : cette chambre 1 comprend en particulier au moins un porte cible de pulvérisation cathodique, noté 7 dans la figure, destiné à recevoir une cible de pulvérisation.

Le porte cible de pulvérisation 7 peut recevoir une seule cible de pulvérisation. Dans ce cas, cette cible est en un alliage de Cu-In-Ga.

Mais il peut y avoir également, soit deux porte-cibles recevant chacun une cible de pulvérisation, soit deux cibles de pulvérisation cathodique supportées sur le même porte cible, par exemple l'une des cibles étant en un alliage de Cu Ga, et l'autre des cibles étant en In.

Mais il peut encore y avoir trois cibles de pulvérisation cathodique placées sur le même porte cible de pulvérisation cathodique représenté dans la figure ou encore trois cibles placées sur trois porte cibles. Par exemple l'une des cibles est en Cu, l'autre en Ga et la troisième en In.

Ce au moins un porte cible de pulvérisation cathodique 7 est situé en vis-à-vis d'un porte substrat, noté 6 dans la figure, qui destiné à recevoir un substrat sur au moins une surface duquel on veut déposer le film mince.

Si le dispositif de l'invention ne comprend qu'une cible, le porte cible sera avantageusement parallèle au substrat.

Si le dispositif de l'invention comporte deux ou plus cibles, il sera avantageux de positionner ces cibles de façon symétrique et légèrement convergente vers une zone du porte-substrat.

Le porte substrat 6 est muni de moyens de chauffage, non représentés, du substrat.

Si nécessaire la chambre 1 peut être également munie d'une entrée de vide et d'un dispositif de mise sous vide.

Le dispositif de l'invention comprend également une enceinte, notée 2 dans la figure, destinée à vaporiser l'élément X ou décomposer et vaporiser le précurseur de celui-ci, comme on le verra par la suite.

Cette enceinte 2 est séparée de la chambre 1 mais reliée à celle-ci par l'intermédiaire d'un tube d'injection, noté 3 dans la figure, muni de moyens de chauffage non représentés.

L'entrée du tube d'injection 3, est située sur les parois de la chambre 1, mais sous le porte substrat 6 pour permettre la mise en contact de l'élément X vaporisé et du substrat.

Ainsi, les vapeurs de l'élément X entrent dans la chambre 1 sous la forme d'un premier flux laminaire dont le chemin de passage est représenté par les flèches notées 9 dans la figure. Lorsque les vapeurs de l'élément X entrent en contact avec le substrat, l'élément X présent en excès sur le substrat chauffé est réévaporé puis emporté par le premier flux laminaire contenant l'élément X comme montré par les flèches notées 5 dans la figure.

Pour permettre de déposer le film mince voulu en une seule étape tout en évitant le dépôt de X sur les parois froides du dispositif, le dispositif de l'invention comprend de plus un tube d'injection noté 4 dans la figure d'un gaz inerte, tel que l'argon, l'hélium ou l'azote dans la chambre 1.

De préférence, le gaz sera de l'argon.

Le tube d'injection 4 a son entrée située sous l'entrée du tube d'injection 3 et injecte un second flux laminaire de préférence de l'argon, sous le premier flux laminaire transportant l'élément X sous forme vapeur. Ce second flux laminaire suit le trajet représenté par les flèches notées 12 dans la figure.

L'injection simultanée de ces deux flux laminaires permet de confiner les vapeurs de l'élément X à proximité de la surface du substrat et ainsi d'éviter les dépôts parasites de X sur la cible de pulvérisation et sur les parois froides de la chambre 1.

La chambre 1 comprend également des moyens d'évacuation des flux laminaires gazeux et, bien sûr, des moyens de pulvérisation de la ou des cibles de pulvérisation.

Ainsi, le procédé d'invention consiste à déposer, par pulvérisation cathodique d'au moins une cible de pulvérisation cathodique les éléments métalliques Cu, In et Ga sur au moins une surface d'un substrat chauffé grâce au moyen de chauffage du porte substrat 6.

De façon générale, l'élément X est amené sous forme de vapeur :

- soit l'élément X est vaporisé dans l'enceinte 2 et introduit sous forme de vapeur par le tube d'injection chauffé 3. Le tube d'injection 3 est chauffé à une température suffisante pour maintenir l'élément X sous forme vapeur. L'élément X est entraîné dans la chambre 1 par un gaz inerte tel que l'argon, l'azote ou l'hélium, sous la forme d'un premier flux laminaire. De préférence on utilisera l'argon. A cet effet, l'enceinte 2 est munie de moyen de vaporisation de l'élément X et d'une entrée de gaz inerte noté 10 dans la figure,

- soit un gaz d'un précurseur de X ayant ou non subi un plasma est amené dans la chambre 1, auquel cas l'enceinte est munie de moyens pour décomposer le précurseur et le vaporiser. Dans ce cas, lorsque le précurseur de X décomposé sous forme gazeuse arrive au contact de la surface sur laquelle le film doit être déposé, il réagit chimiquement avec cette surface.

Dans tous les cas, en même temps que l'élément X sous forme vapeur est introduit dans la chambre 1, un second flux laminaire de gaz inerte est introduit sous le premier flux contenant l'élément X ou son précurseur. Selon un chemin de passage parallèle à celui du premier flux laminaire, qui passe sous le premier flux laminaire, c'est-à-dire entre le premier flux laminaire et la ou les cibles de pulvérisation cathodique.

Ainsi, la chambre 1 comprend également un tube d'injection noté 4 dans la figure, d'un gaz inerte, tel que l'argon, l'hélium ou l'azote.

De préférence, il s'agira d'argon.

La chambre 1 comprend également un tube d'évacuation de ce gaz inerte et, bien sûr, des moyens pour pulvériser la ou les cibles.

Si nécessaire, la chambre 1 peut également être munie d'une entrée de vide et d'un dispositif de mise sous vide de l'enceinte.

Le dispositif de l'invention comprend également une enceinte, notée (2) dans la figure, de vaporisation de l'élément X ou de décomposition - vaporisation, d'un précurseur de celui-ci.

Cette enceinte 2 est séparée de la chambre 1 mais reliée à celle-ci par l'intermédiaire d'un tube d'injection, noté 3 dans la figure, muni de moyens de chauffage.

L'entrée du tube d'injection 3, est située sous le porte substrat 10 pour permettre la mise en contact de l'élément X vaporisé et du substrat.

Ainsi, les vapeurs de l'élément X entrent dans la chambre 1 sous la forme d'un premier flux laminaire dont le chemin de passage est représenté par les flèches notées 9 dans la figure. Lorsque les vapeurs de l'élément X entrent en contact avec le substrat, l'élément X présent en excès sur le substrat chauffé est réévaporé puis emporté par le flux laminaire de l'élément X comme montré par les flèches notées 5 dans la figure. Ceci permet de déposer le film mince voulu en une seule étape et éviter le dépôt de X sur les parois froides du dispositif.

Le tube d'injection 4 a son entrée située sous l'entrée du tube d'injection 3 et injecte un second flux laminaire de gaz inerte, de préférence de l'argon, sous le premier flux laminaire transportant l'élément X sous forme vapeur. Ce second flux laminaire suit le trajet représenté par les flèches notées 12 dans la figure.

Le second flux laminaire de gaz inerte permet de confiner les vapeurs de l'élément X à proximité de la surface du substrat et ainsi d'éviter les dépôts parasites de X sur la cible de pulvérisation et sur les parois froides de la chambre 1.

Ainsi, le procédé de l'invention consiste à déposer par pulvérisation cathodique d'au moins une cible de pulvérisation cathodique les éléments métalliques Cu, In et Ga sur le substrat chauffé sur au moins une surface d'un substrat chauffé grâce au moyen de chauffage du porte substrat 10.

L'élément X est vaporisé, dans l'enceinte 2 et est introduit sous forme de vapeur par le tube d'injection chauffé 3.

Le tube d'injection 3 est chauffé à une température suffisante pour maintenir l'élément X sous forme vapeur.

L'élément X est entraîné dans la chambre 1 par un gaz inerte tel que l'argon, l'azote ou l'hélium.

De préférence on utilisera l'argon. A cet effet, l'enceinte 2 de vaporisation de l'élément X, est munie d'une entrée de gaz inerte, notée 10 dans la figure.

En même temps que l'élément X sous forme vapeur est introduit dans la chambre 1, un second flux laminaire, de gaz inerte, est introduit sous le premier flux de l'élément X et entre ce flux et la ou les cibles de pulvérisation cathodique.

Le premier flux laminaire de l'élément X est évacué de la chambre 1 par le tube d'évacuation noté 13 dans la figure et le flux de gaz inerte est évacué de la chambre 1 par le tube d'évacuation noté 14 dans la figure.

Le premier flux laminaire de l'élément X est donc formé par passage de gaz inerte à travers l'enceinte 2 de vaporisation de l'élément X, le mélange gazeux étant ensuite conduit dans le tube d'injection 3.

Ce tube d'injection 3 doit être chauffé, dans le cas du sélénium, à une température supérieure à 200°C, afin d'éviter la condensation du sélénium avant injection.

L'élément X présent en excès sur le substrat chauffé est réévaporé et emporté dans le flux laminaire des vapeurs X comme représenté dans la figure par les flèches notées 5.

Le second flux laminaire de gaz inerte joue un rôle crucial pour protéger la cible de pulvérisation ainsi que les parois froides de l'enceinte 1 car les vapeurs de l'élément X diffusant du premier flux le contenant sous forme de vapeur vers le second flux de gaz inerte sont rapidement emportées par le second flux de gaz inerte avant de pouvoir atteindre la cible de pulvérisation ou les parois froides.

Les deux flux sont des flux laminaires.

Afin de se placer en régime laminaire, le nombre de Knudsen $K$ doit être inférieur à 0,01 pour éviter le régime moléculaire et le nombre de Reynolds $R$ doit être inférieur à 1000 pour éviter le régime turbulent.

Le nombre de Knudsen est donné par la formule :

$$K = L/a,$$

où $L$ est le libre parcours moyen dans le gaz, c'est-à-dire la distance moyenne parcouru par un atome ou une molécule entre deux collisions cette distance est inversement proportionnelle à la pression du gaz et, $a$ une longueur caractéristique de l'ordre de distance entre la cible de pulvérisation et le substrat.

Le nombre de Reynolds est donné par la formule :

$$R = v\rho a/\eta,$$

où $v$ est la vitesse d'écoulement du flux gazeux, $\rho$ la densité du gaz, et $\eta$ la viscosité du gaz.

Ainsi, pour une géométrie donnée, et pour un mélange gazeux donné, se placer en régime laminaire demande d'avoir une pression suffisamment élevée, (c'est-à-dire un libre parcours moyen suffisamment faible) et une vitesse d'écoulement suffisamment faible.

Un premier compromis se situe au niveau de la pression du gaz : une pression élevée est nécessaire pour éviter le régime moléculaire, alors qu'une pression faible favorise une vitesse de dépôt élevée des éléments pulvérisés.

Il faut donc diminuer la pression tout en restant dans le cas $K < 0,01$.

Pour une distance typique entre la cible de pulvérisation et le substrat de l'ordre de 10 cm, le libre parcours moyen $L$ doit être de l'ordre de 1 mm pour avoir $K \approx 0,01$, soit une pression de quelques dizaines de mTorr aux températures considérées.

Une telle pression reste compatible avec des vitesses de dépôt élevées en mode magnétron.

Un second compromis se situe au niveau de la vitesse d'écoulement du flux gazeux : une vitesse d'écoulement faible est nécessaire pour éviter le régime turbulent, alors qu'une vitesse d'écoulement élevée favorise une protection efficace de la cible de pulvérisation et des parois froides contre les vapeurs de l'élément X : plus la vitesse d'écoulement est élevée, plus les vapeurs de l'élément X ayant diffusé du flux le contenant sous forme vapeur vers le flux de gaz inerte seront rapidement emportées par le flux de gaz inerte, ce qui signifie que leur temps de présence à proximité de la cible ou des parois froides sera plus court.

Autrement dit, il faut que les deux flux gazeux soient laminaires mais à la limite de la turbulence, c'est-à-dire, qu'ils aient chacun indépendamment l'un de l'autre un nombre de Reynolds $\leq$1000 et, de préférence, que la vitesse du second flux laminaire gazeux soit supérieure à la vitesse du premier flux gazeux laminaire.

Pour améliorer encore le dispositif et le procédé de l'invention, une grille notée 8 dans la figure, éventuellement refroidie, peut être placée à l'interface entre les deux flux laminaires, dans le dispositif de l'invention, afin d'agir comme un piège froid pour les vapeurs de Se ou de S.

Ainsi, dans le procédé de l'invention, le premier flux contenant l'élément X sous forme de vapeur sera introduit entre le substrat et la grille refroidie 8 et le second flux de gaz inerte sera introduit entre la grille 8 et la cible de pulvérisation cathodique.

L'élément X peut être obtenu soit par vaporisation de l'élément X lui-même, soit par réaction chimique sur le substrat de l'un de ses précurseurs, tels que des molécules de formule $R_2X$ avec R = H, Me (méthyle), Et (éthyle), iPr (isopropyle) ou tBu (tertiobutyle).

Ces molécules précurseurs peuvent être décomposées par plasma dans l'enceinte 2, avant injection du gaz.

Ainsi, l'enceinte 2 peut de plus comprendre un dispositif de décomposition de molécules par plasma.

Quant à la ou les cibles de pulvérisation cathodique, elles peuvent être des cibles cylindriques en rotation.

Afin de mieux faire comprendre l'invention, on va maintenant en décrire, à titre d'exemple purement illustratif et non limitatif, un mode de mise en oeuvre.

Exemple.

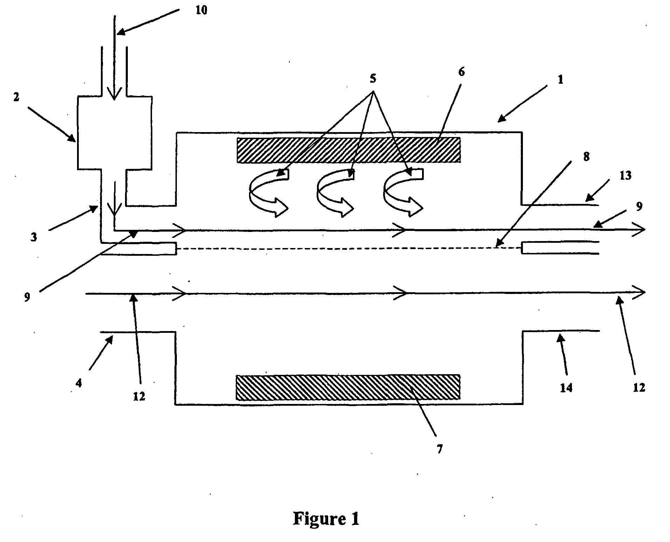

Un dispositif tel montré en figure 1 est utilisé.

Le substrat est chauffé à 820 *K.*

La distance *a* entre la cible de pulvérisation et le substrat est de 10 cm.

La pression est de 6,7Pa (50 mTorr).

Le premier flux gazeux contenant Se et de l'argon est chauffé à 600K et est injecté par l'orifice 3, en même temps qu'un second flux gazeux de gaz inerte, ici de l'argon, qui est également chauffé à 600*K.* Les vitesses des premier et second flux gazeux sont toutes deux de 1 0m/s.

Ainsi, ces flux gazeux ont un nombre de Knudsen *K* d'environ $10^{-2}$.

Le coefficient de Reynolds de ces deux flux gazeux est égal à 2.

Le substrat est revêtu d'un film de Cu (In, Ga) $Se_2$ par pulvérisation cathodique d'une cible constituée de Cu (In, Ga) et simultanément injection des deux flux gazeux précédemment décrits.

**Revendications**

1. Dispositif pour le dépôt d'un film de Cu(In,Ga)$X_2$, où X est Se ou S ou un mélange de ceux-ci, sur au moins une surface d'un substrat, comprenant une chambre (1) de pulvérisation cathodique, comprenant :

   - un porte-substrat (6),
   - un moyen de chauffage du porte-substrat,
   - au moins un porte cible de pulvérisation (7), le porte substrat (6) étant situé en regard du au moins un porte cible de pulvérisation (7), et écarté de celui-ci,
   - un premier tube d'injection (3) d'un premier flux laminaire de gaz inerte contenant X, ou un précurseur de X, sous forme vapeur,
   **caractérisé en ce qu'**il comprend, de plus un second tube d'injection (4) d'un second flux laminaire de gaz inerte dont l'orifice d'entrée dans la chambre (1) est situé entre l'orifice d'entrée dans la chambre (1) du premier tube d'injection (3) et le au moins porte cible (7), de sorte que le second flux laminaire de gaz inerte entrant par l'orifice d'entrée du second tube d'injection (4) est parallèle au premier flux laminaire de gaz inerte contenant X, ou un précurseur de celui-ci, sous forme vapeur, et confine le premier flux laminaire de gaz inerte contenant X, ou un précurseur de X, sous forme vapeur, au voisinage du porte substrat (6).

2. Dispositif selon la revendication 1 **caractérisé en ce qu'**il comprend de plus une enceinte (2) comprenant des moyens de vaporisation de X, l'enceinte (2) étant en relation de fluide avec le premier tube d'injection (3) et la chambre (1).

3. Dispositif selon la revendication 1 **caractérisé en ce qu'**il comprend de plus une enceinte (2) comprenant des moyens pour créer un plasma pour décomposer et vaporiser le précurseur de X, l'enceinte 2 étant relation de fluide avec le premier tube d'injection (3) et la chambre (1).

4. Dispositif selon l'une quelconque des revendications précédentes **caractérisé en ce que** la chambre (1) comprend de plus une grille (8), éventuellement munie de moyens de refroidissement, s'étendant sur toute la longueur de la chambre (1) parallèlement au porte-substrat (6) et entre l'orifice d'entrée du premier tube d'injection (3) et l'orifice du second tube d'injection (4).

5. Dispositif selon l'une quelconque des revendications précédentes caractérisé en qu'il comprend deux cibles de pulvérisation situées l'une à côté de l'autre.

6. Dispositif selon l'une quelconque des revendications 1 à 4 **caractérisé en ce qu'**il comprend trois cibles de pulvérisation situées les unes à côtés des autres.

7. Procédé de dépôt d'un film en Cu(In,Ga)$X_2$ où X est Se ou S, ou leur mélange comprenant :

   une étape de dépôt, par pulvérisation cathodique, de Cu, In et Ga à partir d'au moins une cible de pulvérisation, sur au moins une surface d'un substrat, simultanément à une étape de dépôt en phase vapeur de X sur ladite au moins une surface dans une chambre cathodique (1), **caractérisé en ce que** X, ou un précurseur de celui-ci, sous forme vapeur, est amené sous forme d'une premier flux gazeux laminaire dont le chemin de parcours est parallèle à la au moins une surface du substrat et en contact avec celle-ci, simultanément avec un second flux gazeux laminaire de gaz inerte dont le chemin de parcours est :

- parallèle au chemin de parcours du premier flux gazeux laminaire, et
- entre le chemin de parcours du premier flux gazeux laminaire et la surface de la (des) cible(s) de pulvérisation,

confinant ainsi le premier flux gazeux laminaire au voisinage du substrat.

**8.** Procédé selon la revendication 7 **caractérisé en ce que** la vitesse du second flux laminaire gazeux est supérieure à la vitesse du premier flux laminaire gazeux.

**9.** Procédé selon la revendication 7 ou 8, **caractérisé en ce que** les premier et second flux laminaires gazeux ont chacun indépendamment l'un de l'autre un nombre de Knudsen $K = L/a$ où $L$ est la distance moyenne parcourue par un atome ou une molécule entre deux collisions et a est la distance entre la (les) cible(s) de pulvérisation et le substrat, tel que $K \leq 10^{-2}$.

**10.** Procédé selon l'une quelconque des revendications 7 à 9, **caractérisé en ce que** le premier et le second flux laminaires gazeux ont chacun indépendamment l'un de l'autre un nombre de Reynolds R<1000.

**11.** Procédé selon l'une quelconque des revendications 7 à 10 **caractérisé en ce que** X est déposé à partir d'un précurseur de X, de formule $R_2X$ où R est H, Me,Et, iPr ou tBu.

**12.** Procédé selon l'une quelconque des revendications 7 à 10, **caractérisé en ce que** X est vaporisé et entraîné dans ledit premier flux laminaire gazeux contenant un gaz inerte tel que l'argon dans la chambre (1).

**13.** Procédé selon l'une quelconque des revendications 7 à 12, **caractérisé en ce que** ledit second flux laminaire est un flux laminaire d'argon.

**14.** Procédé selon la revendication 11, **caractérisé en ce que** le précurseur de X est décomposé par plasma avant injection dans la chambre (1).

**15.** Procédé selon l'une quelconque des revendications 7 à 14 **caractérisé en ce que** ledit premier flux laminaire et ledit second flux laminaire sont séparés l'un de l'autre par une grille (8).

**16.** Procédé selon la revendication 15, **caractérisé en ce que** la grille (8) est refroidie.

**Patentansprüche**

**1.** Vorrichtung zum Abscheiden einer Schicht aus Cu

$(In,Ga)X_2$, wobei X Se oder S oder eine Mischung aus diesen ist, auf wenigstens einer Oberfläche eines Substrats, mit einer Kathodenzerstäubungskammer (1), umfassend:

- einen Substrathalter (6),
- ein Mittel zum Erwärmen des Substrathalters,
- wenigstens ein Zerstäubungstargethalter (7), wobei der Substrathalter (6) gegenüber von wenigstens einem Zerstäubungstargethalter (7) und zu diesem beabstandet angeordnet ist,
- ein erstes Einstrahlrohr (3) eines ersten laminaren Edelgasstroms, der X oder ein Vorprodukt von X in Dampfform enthält, **dadurch gekennzeichnet, dass** sie ferner ein zweites Einstrahlrohr (4) eines zweiten laminaren Edelgasstroms umfasst, dessen Eintrittsöffnung in die Kammer (1) zwischen der Eintrittsöffnung in die Kammer (1) des ersten Einstrahlrohrs (3) und dem wenigstens einen Zerstäubungstargethalter (7) angeordnet ist,
derart, dass die zweite Edelgasstrom, der durch die Eintrittsöffnung des zweiten Einstrahlrohrs (4) eintritt, parallel zu dem ersten Edelgasstrom ist, der X oder ein Vorprodukt von diesem in Dampfform enthält, und den ersten Edelgasstrom, der X oder ein Vorprodukt von X in Dampfform enthält, in der Umgebung des Substrattägers (6) hält.

**2.** Vorrichtung nach Anspruch 1, **dadurch gekennzeichnet, dass** sie ferner ein Gehäuse (2) umfasst, das Mittel zum Verdampfen von X umfasst, wobei das Gehäuse (2) in Fluidverbindung mit dem ersten Einstrahlrohr (3) und der Kammer (1) ist.

**3.** Vorrichtung nach Anspruch 1, **dadurch gekennzeichnet, dass** sie ferner ein Gehäuse (2) umfasst, das Mittel zum Erzeugen eines Plasmas zum Trennen und Verdampfen des Vorprodukts von X umfasst, wobei das Gehäuse (2) in Fluidverbindung mit dem ersten Einstrahlrohr (3) und der Kammer (1) ist.

**4.** Vorrichtung nach einem der vorhergehenden Ansprüche, **dadurch gekennzeichnet, dass** die Kammer (1) ferner ein Gitter (8) umfasst, das optional mit einem Kühlmittel ausgestattet ist und sich über die gesamte Länge der Kammer (1) parallel zu dem Trägersubstrat (6) und zwischen der Eintrittsöffnung des ersten Einstrahlrohrs (3) und der Öffnung des zweiten Einstrahlrohrs (4) erstreckt.

**5.** Vorrichtung nach einem der vorhergehenden Ansprüche, **dadurch gekennzeichnet, dass** sie zwei Zerstäubungstargets umfasst, die nebeneinander angeordnet sind.

**6.** Vorrichtung nach einem der Ansprüche 1 bis 4, **da-**

**durch gekennzeichnet, dass** sie drei Zerstäubungstargets umfasst, die nebeneinander angeordnet sind.

7. Verfahren zum Abscheiden einer Schicht aus Cu(In, Ga)X$_2$, wobei X entweder Se oder S oder eine Mischung aus diesen, umfassend:

   einen Schritt zum Abscheiden, durch Kathodenzerstäubung, von Cu, In und Ga von wenigstens einem Zerstäubungstarget auf wenigstens eine Oberfläche eines Substrats gleichzeitig mit einem Schritt zum Abscheiden von X aus der Dampfphase auf der wenigstens eine Oberfläche in einer Kathodenkammer (1), **dadurch gekennzeichnet, dass** X oder eine Vorstufe von diesem, in Dampfform, in Form eines ersten laminaren Gasstroms, dessen Strömungsweg parallel zu der wenigstens einen Oberfläche des Substrats und in Kontakt mit diesem ist, gleichzeitig geführt wird mit einem zweiten laminaren Gasstrom eines Edelgases, dessen Strömungsweg:

   - parallel zu dem Strömungsweg des ersten laminaren Gasstroms, und
   - zwischen dem Strömungsweg des ersten laminaren Gasstroms
   und der Oberfläche des (der) Zerstäubungsziels (Zerstäubungsziele) ist, wodurch der erste laminare Gasstrom in der Umgebung des Substrats gehalten wird.

8. Verfahren nach Anspruch 7, **dadurch gekennzeichnet, dass** die Geschwindigkeit des zweiten laminaren Gasstroms höher als die Geschwindigkeit des ersten laminaren Gasstroms ist.

9. Verfahren nach Anspruch 7 oder 8, **dadurch gekennzeichnet, dass** der erste und zweite laminare Gasstrom jeweils, unabhängig voneinander, eine Knudsen-Zahl K = L/a haben, wobei L die mittlere Strecke ist, die von einem Atom oder einem Molekül zwischen zwei Kollisionen zurückgelegt wird, und a der Abstand zwischen dem (den) Zerstäubungstarget(s) und dem Substrat ist, mit K $\leq$ 10$^{-2}$.

10. Verfahren nach einem der Ansprüche 7 bis 9, **dadurch gekennzeichnet, dass** der erste und zweite laminare Gasstrom jeweils, unabhängig voneinander, eine Reynolds-Zahl R $\leq$ 1000 haben.

11. Verfahren nach einem der Ansprüche 7 bis 10, **dadurch gekennzeichnet, dass** X von einem Vorprodukt von X mit der Formel R$_2$X abgeschieden wird, wobei R entweder H, Me, Et, iPr oder tBu ist.

12. Verfahren nach einem der Ansprüche 7 bis 10, **da-**

**durch gekennzeichnet, dass** X verdampft wird und in der Kammer (1) in dem ersten laminaren Gasstrom mitgenommen wird, der ein Edelgas wie etwa Argon enthält.

13. Verfahren nach einem der Ansprüche 7 bis 12, **dadurch gekennzeichnet, dass** der zweite laminare Gasstrom ein laminarer Argonstrom ist.

14. Verfahren nach Anspruch 11, **dadurch gekennzeichnet, dass** das Vorprodukt von X vor dem Einstrahlen in die Kammer (1) durch Plasma getrennt wird.

15. Verfahren nach einem der Ansprüche 7 bis 14, **dadurch gekennzeichnet, dass** der erste laminare Gasstrom und der zweite laminare Gasstrom durch ein Gitter (8) voneinander getrennt werden.

16. Verfahren nach Anspruch 15, **dadurch gekennzeichnet, dass** das Gitter (8) gekühlt wird.

**Claims**

1. Device for the deposition of a film of Cu(In,Ga)X$_2$, wherein X is Se or S or a mixture thereof, on at least one surface of a substrate, comprising a cathode sputtering chamber (1) comprising:

   - a substrate carrier (6),
   - a means for heating the substrate carrier,
   - at least one sputtering target carrier (7),
   the substrate carrier (6) being situated opposite at least one sputtering target carrier (7) and at a distance therefrom,
   - a first injection tube (3) for a first laminar flow of inert gas containing X, or a precursor of X, in vapour form,
   **characterised in that** it further comprises a second injection tube (4) for a second laminar flow of inert gas, the inlet orifice of which into the chamber (1) is situated between the inlet orifice into the chamber (1) of the first injection tube (3) and the at least one target carrier (7),
   so that the second laminar flow of inert gas entering through the inlet orifice of the second injection tube (4) is parallel to the first laminar flow of inert gas containing X, or a precursor thereof, in vapour form, and confines the first laminar flow of inert gas comprising X, or a precursor of X, in vapour form, in the vicinity of the substrate carrier (6).

2. Device according to claim 1, **characterised in that** it further comprises an enclosure (2) comprising means for vaporising X, the enclosure (2) being in fluid communication with the first injection tube (3) and the chamber (1).

3. Device according to claim 1, **characterised in that** it further comprises an enclosure (2) comprising means for creating a plasma for decomposing and vaporising the precursor of X, the enclosure (2) being in fluid communication with the first injection tube (3) and the chamber (1).

4. Device according to any one of the preceding claims, **characterised in that** the chamber (1) further comprises a grid (8), optionally provided with cooling means, which extends over the entire length of the chamber (1) parallel to the substrate carrier (6) and between the inlet orifice of the first injection tube (3) and the orifice of the second injection tube (4).

5. Device according to any one of the preceding claims, **characterised in that** it comprises two sputtering targets situated side by side.

6. Device according to any one of claims 1 to 4, **characterised in that** it comprises three sputtering targets situated side by side.

7. Method for depositing a film of $Cu(In,Ga)X_2$ wherein X is Se or S or a mixture thereof, comprising:

a step of deposition, by cathode sputtering, of Cu, In and Ga, starting from at least one sputtering target, on at least one surface of a substrate, simultaneously with a step of vapour deposition of X on said at least one surface in a cathode chamber (1), **characterised in that** X, or a precursor thereof, in vapour form, is supplied in the form of a first laminar flow of gas, the travel path of which is parallel to the at least one surface of the substrate and in contact therewith, simultaneously with a second laminar flow of inert gas, the travel path of which is:

- parallel to the travel path of the first laminar flow of gas, and
- between the travel path of the first laminar flow of gas and the surface of the sputtering target(s),

thus confining the first laminar flow of gas in the vicinity of the substrate.

8. Method according to claim 7, **characterised in that** the speed of the second laminar flow of gas is greater than the speed of the first laminar flow of gas.

9. Method according to claim 7 or 8, **characterised in that** the first and second laminar flows of gas each independently of the other has a Knudsen number

$K = L/a$, where $L$ is the mean distance travelled by an atom or a molecule between two collisions and $a$ is the distance between the sputtering target(s) and the substrate, such that $K \leq 10^{-2}$.

10. Method according to any one of claims 7 to 9, **characterised in that** the first and second laminar flows of gas each independently of the other has a Reynolds number $R \leq 1000$.

11. Method according to any one of claims 7 to 10, **characterised in that** X is deposited starting from a precursor of X of the formula $R_2X$ wherein R is H, Me, Et, iPr or tBu.

12. Method according to any one of claims 7 to 10, **characterised in that** X is vaporised and entrained in said first laminar flow of gas comprising an inert gas such as argon in the chamber (1).

13. Method according to any one of claims 7 to 12, **characterised in that** said second laminar flow is a laminar flow of argon.

14. Method according to claim 11, **characterised in that** the precursor of X is decomposed by plasma before being injected into the chamber (1).

15. Method according to any one of claims 7 to 14, **characterised in that** said first laminar flow and said second laminar flow are separated from one another by a grid (8).

16. Method according to claim 15, **characterised in that** the grid (8) is cooled.

**Figure 1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4798660 A, Ermer
- US 5439575 A

**Littérature non-brevet citée dans la description**

- **NAKADA et al.** *Jpn.J.Appl.Phys.,* 1995, vol. 34, 4715